# EUROPÄISCHE PATENTSCHRIFT

(11) **EP 1 397 694 B1**
(45) Veröffentlichungstag und Bekanntmachung des Hinweises auf die Patenterteilung: **23.07.2008**
(21) Anmeldenummer: 02754178.8
(22) Anmeldetag: 29.05.2002
(51) Int. Cl.: G01R 31/00, G01R 35/00, B60R 16/02, G06F 11/22

(54) **VERFAHREN ZUR ÜBERWACHUNG EINER SPANNUNGSVERSORGUNG EINES STEUERGERÄTS IN EINEM KRAFTFAHRZEUG**
METHOD FOR MONITORING A POWER SUPPLY OF A CONTROL UNIT IN A MOTOR VEHICLE
PROCEDE DE SURVEILLANCE D'UNE ALIMENTATION EN TENSION D'UN APPAREIL DE COMMANDE DANS UNE AUTOMOBILE

(30) Priorität: 02.06.2001 DE 10127054
(43) Veröffentlichungstag der Anmeldung: 17.03.2004
(73) Patentinhaber: ROBERT BOSCH GMBH, 70442 Stuttgart (DE)
(72) Erfinder: SIEVERS, Falko, 72827 Wannweil (DE); SCHUMACHER, Hartmut, 71691 Freiberg (DE); TAUFER, Peter, 71272 Renningen (DE); SEIBOLD, Jochen, 72070 Tübingen (DE); TSCHENTSCHER, Harald, 71723 Grossbottwar (DE); NITSCHE, Gerald, 72501 Gammertingen (DE)
(86) Internationale Anmeldenummer: PCT/DE2002/001974
(87) Internationale Veröffentlichungsnummer: WO 2002/099444

(56) Entgegenhaltungen:
- EP-A- 1 001 257
- DE-A- 4 433 745
- US-A- 4 597 052
- US-A- 4 694 408

## Beschreibung

### Stand der Technik

Die Erfindung geht aus von einem Verfahren zur Überwachung einer Spannungsversorgung eines Steuergeräts in einem Kraftfahrzeug nach der Gattung des unabhängigen Patentanspruchs.

Überwachungseinrichtungen sind bekannt aus EP1001257, US 4597052 und DE4433745.

Es ist bereits bekannt, daß bei einer Spannungsversorgung in einem Steuergerät Fehler bei den Spannungen, die zur Versorgung der Komponenten des Steuergeräts verwendet werden, erkannt werden können und dann über eine RESET-Leitung, ausgehend von einem Versorgungsbaustein, die Komponenten des Steuergeräts in ihrer Funktion unterbrochen werden. Es findet ein Stillsetzen statt. Die Spannungen werden mit Bändern um einen Vorgabewert auf Fehler überwacht.

### Vorteile der Erfindung

Das erfindungsgemäße Verfahren zur Überwachung einer Spannungsversorgung eines Steuergeräts in einem Kraftfahrzeug mit den Merkmalen des unabhängigen Patentanspruchs hat demgegenüber den Vorteil, daß auch ein Test der RESET-Leitung durchgeführt wird, wobei eine gefahrlose Simulation eines Fehlers ermöglicht wird. Dies liefert den Hinweis, daß die Überwachungsschaltung aktiv ist und führt damit zu einer erhöhten Sicherheit der Funktion des Steuergeräts. Diese Methode ist insbesondere für die Fälle anwendbar, bei denen mehr als eine Versorgungsspannung von dem Versorgungsbaustein bereitzustellen ist. Das sind dann beispielsweise 5 V, 3,3 V und 1,8 V.

Durch die in den abhängigen Ansprüchen aufgeführten Maßnahmen und Weiterbildungen sind vorteilhafte Verbesserungen des im unabhängigen Patentanspruch angegebenen Verfahrens zur Überwachung einer Spannungsversorgung eines Steuergeräts in einem Kraftfahrzeug möglich.

Besonders vorteilhaft ist, daß bei dem Test der RESET-Leitung abwechselnd die Grenzen der Bänder, mit denen die Versorgungsspannungen überwacht werden, über beziehungsweise unter den Vorgabewert verzogen werden, so daß ein RESET erzwungen wird. Damit ist die Wirkung für den Prozessor klar, und der Prozessor zählt die Zeit, wie lange ein RESET-Impuls andauert. Damit ist dann die Funktionsweise der RESET-Leitung überprüfbar. Weiterhin ist dabei von Vorteil, daß beide Grenzen getestet werden. Dies erhöht die Sicherheit des erfindungsgemäßen Verfahrens.

Darüber hinaus ist es von Vorteil, daß das erfindungsgemäße Verfahren beim Neustart eines Steuergeräts durchgeführt wird, so daß immer zu Betriebsbeginn die Funktionsfähigkeit überwacht wird.

Die Komponenten des Steuergeräts, die bei einem Fehler angehalten werden, werden erst wieder aktiv, wenn der Versorgungsbaustein für alle seine Überwachungsfunktionen Fehlerfreiheit signalisiert, damit wird vorteilhafterweise erreicht, dass das Steuergerät nur arbeitet, wenn Fehlerfreiheit vorhanden ist. Dies ist bei einem solchen sicherheitskritischen System, wie es Rückhaltesysteme sind, von großem Vorteil, um Fehlfunktionen zu vermeiden.

Es ist weiterhin von Vorteil, daß wenigstens zwei unabhängige Spannungen bereitgestellt werden, wobei die erste zur Regelung und die zweite zur Überwachung verwendet werden. Damit ist ausgeschlossen, daß ein Fehler, der nur eine der Spannungen betrifft, Rückwirkungen auf die zweite Spannung hat und damit zu einer Fehlerfortpflanzung führen würde. Um die zwei unabhängigen Spannungen zu erzeugen, sind entweder zwei voneinander getrennte Spannungsquellen oder eine Spannungsquelle mit zwei angeschlossenen Impedanzwandlern notwendig.

Beim Scheitern des Tests der RESET-Leitung wird eine Warnung oder eine Sperrung der Funktion des Steuergeräts durchgeführt. Damit wird verhindert, daß ein fehlerhaftes Steuergerät zu gefährlichen Situationen führt, was insbesondere für Steuergeräte für Rückhaltesysteme von Interesse ist.

Es ist darüber hinaus von Vorteil, daß ein Steuergerät vorhanden ist, das die Mittel zur Durchführung des erfindungsgemäßen Verfahrens aufweist.

### Zeichnung

Ausführungsbeispiele der Erfindung sind in der Zeichnung dargestellt und werden in der nachfolgenden Beschreibung näher erläutert. Es zeigt Figur 1 ein Blockschaltbild des erfindungsgemäßen Steuergeräts, Figur 2 ein Flußdiagramm des erfindungsgemäßen Verfahrens, Figur 3 ein Spannungs-Zeit-Diagramm, das den Verlauf einer Spannung mit den Grenzen eines Überwachungsbandes und einem Vorgabewert darstellt, Figur 4 eine Testsequenz von RESET-Impulsen in einem Spannungs-Zeit-Diagramm, Figur 5 ein Blockschaltbild eines erfindungsgemäßen Versorgungsbausteins, Figur 6 zwei Spannungsquellen zur Bereitstellung der Regel- und Testspannung, Figur 7 eine Spannungsquelle mit zwei Impedanzwandlern zur Bereitstellung der Regelspannung und Testspannung und Figur 8 eine Band-Gap-Spannungsreferenz.

### Beschreibung

Bei sicherheitskritischen Systemen in Kraftfahrzeugen, in denen Steuergeräte integriert sind, sind die bereitzustellenden Versorgungsspannungen zu überwachen, denn eine korrekte Funktion der Komponenten des Steuergeräts ist nur bei Versorgungsspannungen, die sich innerhalb vorgegebener Parameter befinden, zu gewährleisten.

Erfindungsgemäß wird nun ein Verfahren zur Überwachung einer Spannungsversorgung eines Steuergeräts in einem Kraftfahrzeug vorgeschlagen, bei dem ein Fehler während eines Tests gefahrlos simuliert werden kann. Dies wird insbesondere bei jedem Neustart des Steuergeräts durchgeführt, wobei ein Test der RESET-Leitung, mit der die Komponenten des Steuergeräts in ihrer Funktion unterbrochen werden können, ausgeführt wird. Dabei wird von einem Versorgungsbaustein des Steuergeräts der Test initiiert, so daß die RESET-Leitung mit periodischen Pulsen für eine vorgegebene Zeitdauer die Komponenten und auch den Prozessor des Steuergeräts unterbricht. Der Prozessor zählt dabei die Zeit zwischen den Unterbrechungen, um die Funktionsweise der RESET-Leitung zu überwachen.

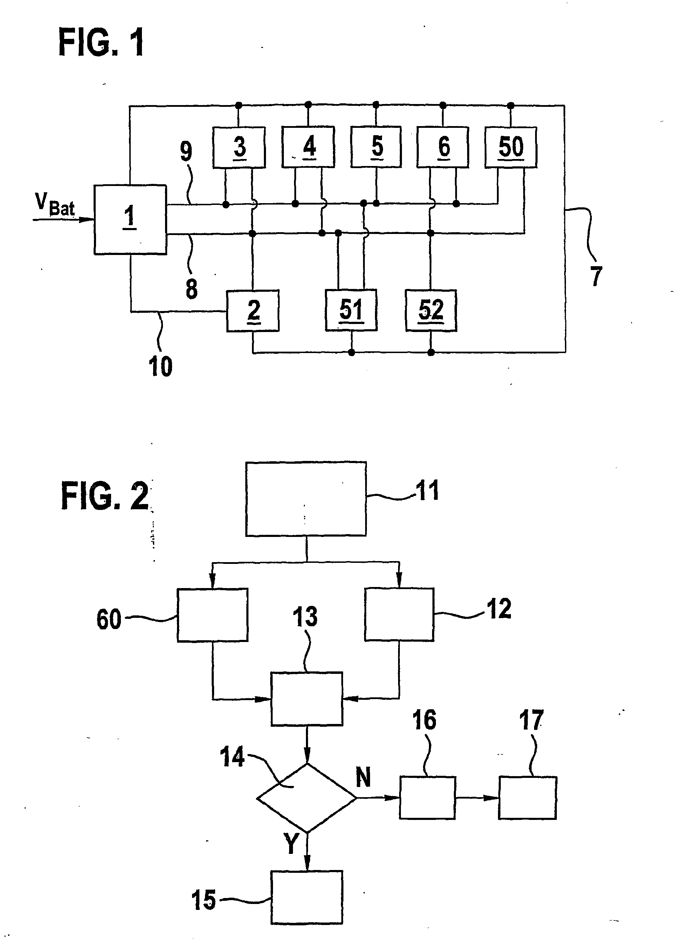

In Figur 1 wird als Blockschaltbild das erfindungsgemäße Steuergerät dargestellt. Ein Versorgungsbaustein 1 wird von einer Batteriespannung VBATT mit der notwendigen elektrischen Energie versorgt, um für die einzelnen Komponenten des Steuergeräts die vorgegebenen Spannungen bereitzustellen. Über eine erste elektrische Energieversorgungsleitung 9 ist der Versorgungsbaustein 1 mit einem Beschleunigungssensor 5, einem Drehratensensor 6, einem Controller 4, einer Zündkreisansteuerung 3, einer PAS (Peripherial Acceleration Sensor)-Schnittstelle 50 und einer CAN (Controller Area Network)-Busschnittstelle 51 verbunden. PAS-Sensoren sind im Fahrzeug verteilte Beschleunigungssensoren, beispielsweise zur Seitenaufprallsensierung.

Die Energieversorgungsleitung 9 weist eine Spannung von 5 V auf. Darüber hinaus ist der Versorgungsbaustein 1 über eine RESET-Leitung 7 mit allen Komponenten des Steuergeräts verbunden. Über eine zweite Energieversorgungsleitung 8 ist der Versorgungsbaustein 1 mit der Zündkreisansteuerung 3, dem Controller 4, mit der PAS-Schnittstelle 50, mit einer CAN-Busschnittstelle 51, mit einem Prozessor 2 und einem Speicher 52 verbunden. Die Energieversorgungsleitung 8 weist eine Versorgungsspannung von 3,3 V auf. Über eine dritte Energieversorgungsleitung 10, die eine Spannung von 1,8 V aufweist, ist der Versorgungsbaustein 1 mit dem Prozessor 2 verbunden. Hier wird dann insbesondere der Prozessorkern und der Speicherkern des Prozessors 2 mit Spannung versorgt. Es ist möglich, dass die einzelnen Energieversorgungsleitungen 8, 9 und 10 mit weiteren Komponenten wie Schnittstellen, Sensoren und Speichern verbunden sind. Es ist weiterhin möglich, dass mehr oder weniger als drei Versorgungsspannungen von dem Versorgungsbaustein 1 bereitgestellt werden und dass verschiedene Komponenten gleichzeitig mit verschiedenen Spannungsversorgungsleitungen verbunden sind.

Der Versorgungsbaustein 1 setzt die Batteriespannung VBATT in die für die Komponenten notwendigen Versorgungsspannungen des Steuergeräts um. Das heißt, aus der Batteriespannung werden 5 V, 3,3 V und 1,8 V erzeugt. Datenverbindungen, die die Funktion der einzelnen Komponenten betreffen, sind hier der Einfachheit halber weggelassen. Auch Steuerleitungen sind hier nicht eingezeichnet. Nach dem Einschalten wird im Versorgungsbaustein 1 automatisch ein Test initiiert. Dieser Test betrifft hier insbesondere die RESET-Leitung 7, an die die einzelnen Komponenten des Steuergeräts angeschlossen sind. Damit wird sichergestellt, daß bei einem Fehler der Spannungsversorgung die Komponenten angehalten werden, so daß das Steuergerät keine fehlerhaften Signale abgibt, die eventuell zu gefährlichen Situationen im Kraftfahrzeug führen könnten.

Nachdem erstmalig oder erneut alle drei Spannungen 5V, 3,3V und 1,8V innerhalb ihres Überwachungsfensters liegen, startet eine feste Ablaufsteuerung im Versorgungsbaustein 1 den Test des Versorgungsbausteins 1. Der Testvorgang ist Schritt für Schritt über die Reset-Leitung 7 beobachtbar. Da über diese Leitung 7 auch gleichzeitig das System, also alle Komponenten des Steuergeräts, angehalten wird, läßt sich auch die ordnungsgemäße Auswirkung der Reset-Signale auf das System überwachen, beziehungsweise letztlich bestätigen.

Der Versorgungsbaustein 1 erzeugt einen RESET-Puls, der über die RESET-Leitung 7 zu allen Komponenten übertragen wird. Dieser RESET-Puls hält die Komponenten in ihrer Funktion für die Pulsdauer an. Mehrere RESET-Pulse werden jedoch im Test verwendet, so daß der Prozessor 2 die Zeit zwischen den RESET-Pulsen und deren Häufigkeit zählen kann, um festzustellen, ob der RESET-Test erfolgreich ist. Ist der RESET-Test nicht erfolgreich, dann wird eine Warnung ausgegeben, beispielsweise über Anzeigegeräte, und/oder die Funktionen des Steuergeräts werden gesperrt. Ist der Test bestanden, wird das Steuergerät freigegeben. Der Ablauf der RESET-Pulse kann durch eine Ablaufsteuerung realisiert sein, die ein Schieberegister aufweist.

Die RESET-Pulse werden dadurch ausgelöst, daß die Versorgungsspannungen, die mit oberen und unteren Grenzwerten jeweils durch Bänder überwacht werden, durch ein Verziehen dieser Grenzen einen Fehler anzeigen und somit zu einem RESET führen. Da sowohl die obere als auch untere Grenze für jede Versorgungsspannung verzogen wird, um einen Fehler zu produzieren, sind doppelt so viele Tests, also sechs, und damit auch sechs Pulse notwendig, um alle Grenzen der drei Versorgungsspannungen hier zu überprüfen.

In Figur 2 ist als Flußdiagramm das erfindungsgemäße Verfahren dargestellt. In Verfahrensschritt 11 wird das Steuergerät eingeschaltet. Die Batteriespannung Vbatt liegt demnach an. Der Versorgungsbaustein 1 setzt die Batteriespannung Vbatt in die erforderlichen Spannungen für die im Steuergerät befindlichen Komponenten um. Daraufhin führt der Prozessor 2 in Verfahrensschritt 12 Autostart-Programme und eine Vorinitialisierung sich selbst betreffend beziehungsweise der im Steuergerät befindlichen ICs bzw. Komponenten durch. Parallel dazu erfolgt unabhängig in Verfahrensschritt 60 der Test des Versorgungsbausteins 1 durch eine testspezifische Reset-Generierung über die Reset-Leitung 7. Bei einem wesentlichen Fehler die gesamte System-Sperrung einschließlich des Prozessors 2, 4 durch die Reset-Leitung 7 (Reset-Low). In Verfahrensschritt 13 wird bei nicht wesentlichen Fehlern dabei der Test des Versorgungsbausteins 1 ausgewertet. Wird dann in Verfahrensschritt 14 festgestellt, daß der Test in Ordnung war, wird in Verfahrensschritt 15 das Steuergerät in seiner Funktion freigegeben. Wurde jedoch in Verfahrensschritt 14 festgestellt, daß der Test gescheitert ist, dann werden in Verfahrensschritt 16 über Steuerleitungen, beispielsweise SPI (Serial Peripherial Interface), die einzelnen Komponenten des Steuergeräts in einen definiert ungefährlichen Zustand gebracht und in Verfahrensschritt 17 wird eine Warnung abgegeben, und gegebenenfalls erfolgt eine Sperrung der Funktionen des Steuergeräts.

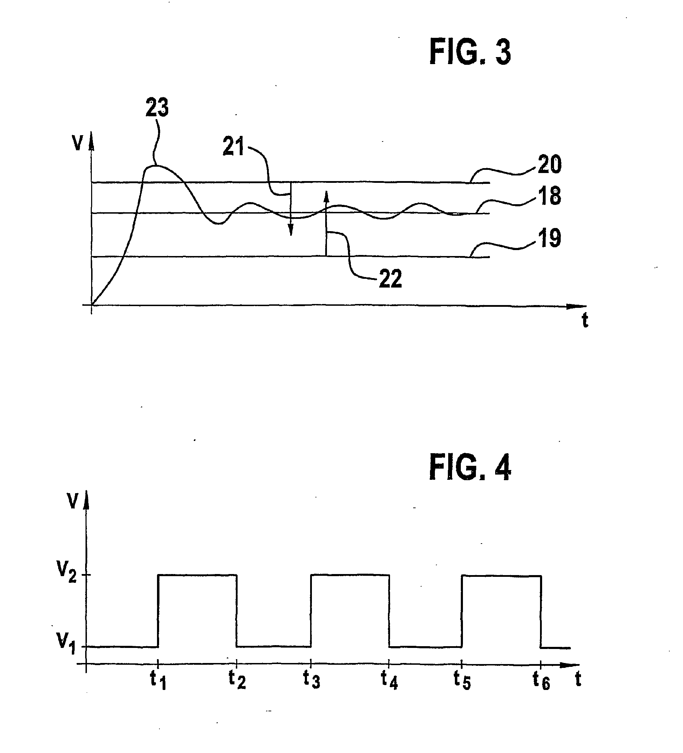

In Figur 3 ist als Spannungs-Zeit-Diagramm der Verlauf der Versorgungsspannung 23 beim Einschalten dargestellt. Für die Versorgungsspannung 23, also entweder 5, 3,3 oder 1,8 V, ist der Vorgabewert 18 von einer oberen Grenze 20 und einer unteren Grenze 19 umgeben. Werden diese Grenzen durch den Spannungswert 23 überschritten, liegt ein Fehler der Versorgungsspannung vor. Nach dem Einlaufen der Spannung in das Überwachungsfenster wird nach einer definierten Filterzeit mit dem Test auf das Über-/Unterschreiten der Grenzen 19 und 20 begonnen. Es wird jedoch eine vorgegebene Zeit abgewartet, bis sich die Versorgungsspannung eingeschwungen hat. Erst dann beginnt der Test auf das Überschreiten der Grenzen 20 und 19. Zur Prüfung wird der dem Vorgabewert 18 unabhängige aber im Wert gleiche Referenzwert (Vref) verwendet. Hierzu wird in der Rückführung der Ausgangsspannung auf den Spannungsregler neben der Ist-Spannung, die über die Regelreferenz (Vregel) liegende Spannung 20, die der oberen Bandgrenze entspricht, und die unter der Regelreferenz liegende Spannung 19, die der unteren Bandgrenze entspricht, ausgekoppelt und mit dem unabhängigen Wert Vref 23 verglichen. Schiebt man den Wert Vref 23 unter die untere Bandgrenze, dann kommt es zu einem Fehler und zu einem Reset-Puls auf der Reset-Leitung 7. Schiebt man den Vref-Wert über die obere Bandgrenze, kommt es zu einem weiteren Fehler und zu einem weiteren Reset-Puls.

In Figur 4 ist als Spannungs-Zeit-Diagramm die Signale auf der RESET-Leitung 7 dargestellt. Während dem Test werden RESET-Impulse erzeugt, die die Komponenten in ihrer Funktion anhalten. Ist die RESET-Leitung 7 auf dem Spannungswert V1, dann sind die Komponenten des Steuergeräts freigegeben. Wird jedoch auf den Spannungswert V2 geschaltet, dann werden die Komponenten in ihrer Funktion angehalten. Hier in Figur 4 sind beispielhaft drei RESET-Impulse dargestellt. Die RESET-Impulse weisen jeweils eine Dauer t2 - t1, t4 - t3 und t6 - t5 auf. Diese Zeitdifferenzen sind jeweils gleich. Der Prozessor zählt nun die Zeiten zwischen t2 und t3 und t4 und t5. Sind diese Zeiten wie vorgegeben, dann ist der RESET-Test bestanden. Die Impulsdauer und die Abstände zwischen den Impulsen können durch Hardware in dem Versorgungsbaustein 1 festgelegt sein, indem Verzögerungsglieder bzw. Schieberegister eingesetzt werden.

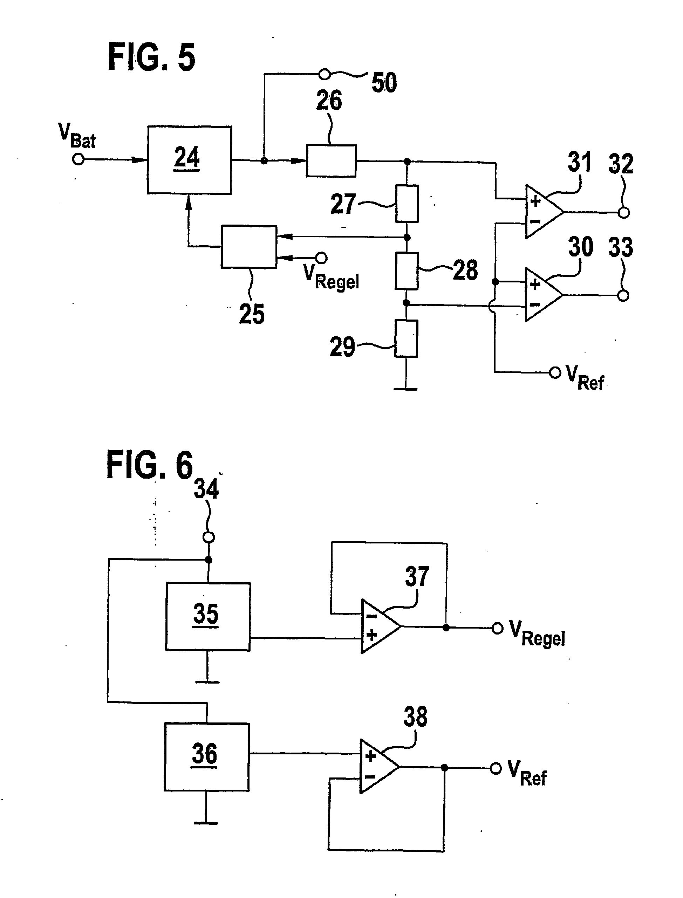

In Figur 5 ist ein Blockschaltbild des erfindungsgemäßen Versorgungsbausteins 1 dargestellt. Die Batteriespannung VBATT liegt an einem Steller 24 an, an dessen zweitem Eingang ein Regler 25 anliegt, der in Abhängigkeit von den Ausgangssignalen den Steller 24 derart beeinflußt, daß eine vorgegebene Ausgangsspannung abgegeben wird. Die Ausgangsspannung des Stellers 24 wird auf einen Spannungsteiler gegeben, der aus den Widerständen 26, 27, 28 und 29 besteht. An den Ausgang des Stellers 24 ist der Widerstand 26 und der Ausgang 50 angeschlossen. Auf der anderen Seite des Widerstands 26 sind der Widerstand 27 und ein positiver Eingang eines Komparators 31 angeschlossen. Der Widerstand 27 ist auf seiner anderen Seite an einen ersten Eingang des Reglers 25 und an den Widerstand 28 angeschlossen. Der Widerstand 28 ist auf seiner anderen Seite an einen negativen Eingang eines Komparators 30 angeschlossen und an den Widerstand 29. Der Widerstand 29 ist auf seiner anderen Seite an Masse angeschlossen.

Die Spannungen, die von den Widerständen 26 und 28 jeweils an die Komparatoreneingänge führen, werden mit einer Referenzspannung VREF verglichen. Die Komparatoren geben dann an ihren Ausgängen 32 und 33 jeweils ein low-Signal beim Unter- oder Überschreiten der Bandgrenzen der hier erzeugten Versorgungsspannung ab. Die Versorgungsspannung ist dabei an dem Ausgang 50 abgreifbar. Die Regelreferenzspannung Vregel ist weiterhin an den zweiten Eingang des Reglers 25 angeschlossen, so daß hier der Vergleich zwischen der Ausgangsspannung des Stellers 24 und der Referenzspannung Vregel stattfindet.

Ein Widerstandsnetzwerk, wie hier dargestellt, das sowohl für die Bereitstellung der Versorgungsspannung als auch für die obere und untere Bandgrenze vorliegt, ist in integrierten Schaltungen sehr einfach und besonders präzise bezüglich der Teilerverhältnisse und der Regler- und Überwachungsgenauigkeit herzustellen. Diese Konfiguration, wie in Figur 5 gezeigt, kann für jede Versorgungsspannung realisiert werden. Liegen demnach drei Versorgungsspannungen vor, dann werden drei solche Schaltungen, wie in Figur 5 dargestellt, verwendet.

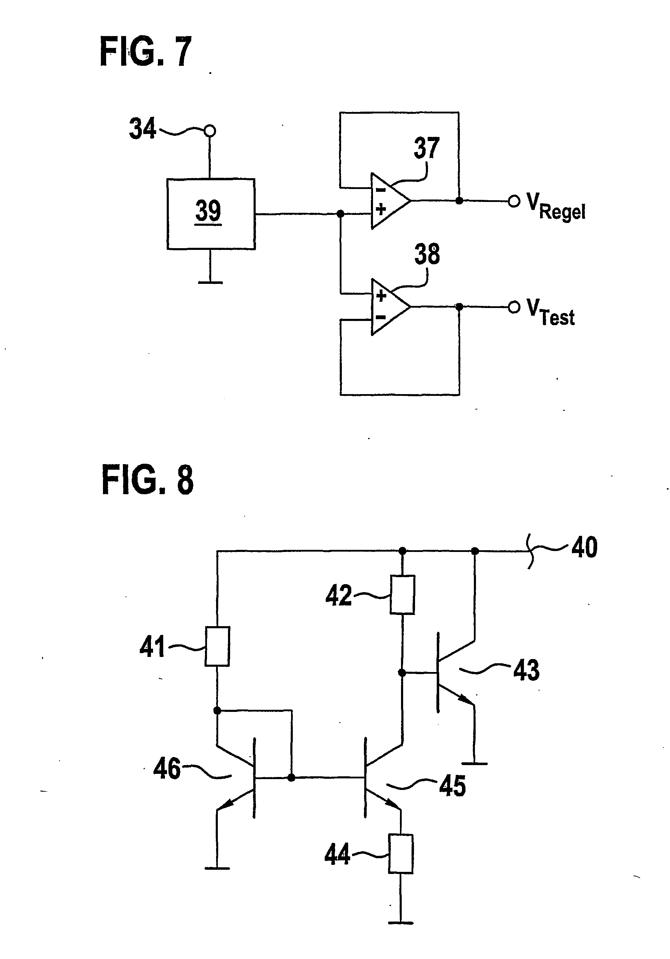

In Figur 6 ist das Blockschaltbild einer Schaltung zur Bereitstellung der Spannungen VREGEL und VREF dargestellt. Mit zwei Spannungsquellen 36 und 35, die parallel geschaltet sind und zwischen einer vorstabilisierten Spannung 34 und Masse liegen, werden jeweils an einen positiven Eingang eines Operationsverstärkers 37 und 38 angeschlossen, wobei der Ausgang des jeweiligen Operationsverstärkers 37 und 38 an den negativen Eingang rückgekoppelt ist. Damit wird ein Impedanzwandler realisiert und die Spannungen VREGEL und VREF, die jeweils an den Ausgängen vorliegen, sind unabhängig voneinander. Dies kann, wie in Figur 7 gezeigt, auch nur durch eine Spannungsquelle 39 realisiert sein, deren Ausgangsspannung dann jeweils an die positiven Eingänge der Operationsverstärker 37 und 38 führt.

In Figur 8 ist dargestellt, wie eine solche Spannungsquelle 39, 35 oder 36 realisiert sein kann. Hier ist es eine sogenannte Band-Gap-Referenz. Am Ausgang 40 liegt eine vom Bandabstand abhängige Spannung 40 vor. Diese Spannung wird hier durch einen Stromspiegel mit einem nachgeschalteten Transistor in Emitterschaltung realisiert. Ein Transistor 46 ist mit seinem Emitter an Masse angeschlossen und sein Kollektor einerseits an einen Widerstand 41 und andererseits an seinen Basisanschluß. Der Basisanschluß des Transistors 46 ist weiterhin an die Basis des Transistors 45 angeschlossen, dessen Emitter über einen Widerstand 44 an Masse angeschlossen ist. Der Kollektor des Transistors 45 führt einerseits zur Basis eines Transistors 43 und andererseits zu einem Widerstand 42. Der Emitter des Transistors 43 ist an Masse angeschlossen, während der Kollektor zum Spannungsausgang 40 führt. Auch der Widerstand 42 und der Widerstand 41 sind jeweils an ihrer anderen Seite an den Ausgang 40 angeschlossen.

Bei der sogenannten Band-Gap-Referenz wird die Spannung zwischen Emitter und Basis als Referenz verwendet, wobei das Grundelement ein Stromspiegel mit den Transistoren 46 und 45 ist. Die beiden Transistoren 46 und 45 haben verschiedene Stromdichten, typischerweise ein Verhältnis von 10 zu 1. Der Strom des Stromspiegels wird über den Widerstand 42 in eine Spannung gewandelt, zu der die Basis-Emitter-Spannung des Transistors 43 addiert wird. Durch den Widerstand 42 kann bei geeigneter Wahl eine Temperaturunabhängigkeit erreicht werden. Dies wird dann erreicht, wenn die gesamte Spannung dem Bandabstand von Silizium entspricht. Dies ist etwa bei 1,22 V. Der Ausgangsstrom über den Widerstand 41 wird als der Konstantstrom benutzt, der für den Stromspiegel benötigt wird.

Der Versorgungsbaustein 1 ist hier als ein IC ausgeführt. Er kann aber auch aus mehreren elektronischen Komponenten zusammengesetzt sein.

## Patentansprüche

1. Verfahren zur Überwachung einer Spannungsversorgung eines Steuergeräts in einem Kraftfahrzeug, wobei bei einem erkannten Fehler bei vorhandenen Spannungen, die von einem Versorgungsbaustein (1) im Steuergerät erzeugt werden, der Versorgungsbaustein (1) Komponenten des Steuergeräts über eine RESET-Leitung (7) in ihrer jeweiligen Funktion unterbricht, wobei die Spannungen durch Bänder (19, 20) und Vorgabewerte (18) auf Fehler überwacht werden, **dadurch gekennzeichnet, daß** ein Test der RESET-Leitung (7) des Steuergeräts eingeleitet wird, wobei dann der Versorgungsbaustein (1) die Komponenten mit periodischen Pulsen über die RESET-Leitung (7) für eine vorgegebene Zeitdauer in ihrer Funktion unterbricht und ein Prozessor (2) die Zeit zwischen den Unterbrechungen zählt, um die Funktionsweise der RESET-Leitung (7) zu überwachen.

2. Verfahren nach Anspruch 1, **dadurch gekennzeichnet, daß** bei dem Test die Grenzen (19, 20) der Bänder abwechselnd über bzw. unter die Vorgabewerte (18, 23) zur Erzwingung der Unterbrechung versetzt werden.

3. Verfahren nach Anspruch 1 oder 2, **dadurch gekennzeichnet, daß** der Test bei jedem Neustart des Steuergeräts durchgeführt wird.

4. Verfahren nach einem der Ansprüche 1 bis 3, **dadurch gekennzeichnet, dass** bei jedem Fehler der überwachten Spannungen die Komponenten angehalten werden, bis alle Überwachungsfunktionen des Versorgungsbausteins (1) Fehlerfreiheit bei den Spannungen signalisieren.

5. Verfahren nach einem der Ansprüche 1 bis 4, **dadurch gekennzeichnet, daß** der Versorgungsbaustein (1) zwei voneinander unabhängige Referenzspannungen bereitstellt, wobei die erste Referenzspannung zur Regelung der Spannungen und die zweite Referenzspannung zur Überwachung der Regelspannung verwendet wird.

6. Verfahren nach einem der Ansprüche 1 bis 5, **dadurch gekennzeichnet, daß** bei einem Scheitern des Tests eine Warnung und/oder Sperrung von Funktionen des Steuergeräts erfolgt.

7. Steuergerät geeignet zur Durchführung aller Schritte des Verfahrens nach einem der Ansprüche 1 bis 6, **dadurch gekennzeichnet, daß** das Steuergerät einen Versorgungsbaustein (1) aufweist, der die Komponenten (2 bis 6, 50-52) des Steuergeräts mit den notwendigen Spannungen versorgt und mit den Komponenten (2 bis 6, 50-52) über die RESET-Leitung (7) verbunden ist, und daß ein Prozessor (2) des Steuergeräts Mittel zur Durchführung des Tests der RESET-Leitung (7) aufweist.

8. Steuergerät nach Anspruch 7, **dadurch gekennzeichnet, daß** der Versorgungsbaustein (1) Mittel zur Bereitstellung von wenigstens zwei unabhängigen Referenzspannungen (VREF, VREGEL) aufweist.

9. Steuergerät nach Anspruch 8, **dadurch gekennzeichnet, daß** der Versorgungsbaustein (1) wenigstens zwei voneinander unabhängige Spannungsquellen (35, 36) zur Bereitstellung der Referenzspannungen (VREGEL, VREF) aufweist.

10. Steuergerät nach Anspruch 8, **dadurch gekennzeichnet, daß** der Versorgungsbaustein (1) eine Spannungsquelle (39) und wenigstens zwei Impedanzwandler (37, 38) zur Bereitstellung der Referenzspannungen aufweist.

## Claims

1. Method for monitoring a voltage supply of a control unit in a motor vehicle, in which, in the event of an error being detected in voltages which are generated by a supply module (1) in the control unit, the supply module (1) interrupts the respective function of components of the control unit via a RESET line (7), the voltages being monitored for errors using bands (19, 20) and predefined values (18), **characterized in that** a test of the RESET line (7) of the control unit is initiated, the supply module (1) then interrupting the function of the components for a predefined period of time using periodic pulses via the RESET line (7), and a processor (2) counting the time between the interruptions in order to monitor the method of operation of the RESET line (7).

2. Method according to Claim 1, **characterized in that**, during the test, the limits (19, 20) of the bands are alternately moved above and below the predefined values (18, 23) in order to force the interruption.

3. Method according to Claim 1 or 2, **characterized in that** the test is carried out each time the control unit is restarted.

4. Method according to one of Claims 1 to 3, **characterized in that**, for each error in the voltages being monitored, the components are stopped until all monitoring functions of the supply module (1) signal that the voltages are free of errors.

5. Method according to one of Claims 1 to 4, **characterized in that** the supply module (1) provides two reference voltages which are independent of one another, the first reference voltage being used to control the voltages and the second reference voltage being used to monitor the control voltage.

6. Method according to one of Claims 1 to 5, **characterized in that** a warning is issued and/or functions of the control unit are blocked when the test fails.

7. Control unit suitable for carrying out all steps of the method according to one of Claims 1 to 6, **characterized in that** the control unit has a supply module (1) which supplies the components (2 to 6, 50-52) of the control unit with the necessary voltages and is connected to the components (2 to 6, 50-52) via the RESET line (7), and **in that** a processor (2) of the control unit has means for testing the RESET line (7).

8. Control unit according to Claim 7, **characterized in that** the supply module (1) has means for providing at least two independent reference voltages (VREF, VCONTROL).

9. Control unit according to Claim 8, **characterized in that** the supply module (1) has at least two voltage sources (35, 36) which are independent of one another and are intended to provide the reference voltages (VCONTROL, VREF).

10. Control unit according to Claim 8, **characterized in that** the supply module (1) has a voltage source (39) and at least two impedance converters (37, 38) for providing the reference voltages.

## Revendications

1. Procédé de surveillance de l'alimentation en tension d'un appareil de commande d'un véhicule automobile selon lequel en cas de défaut reconnu lorsque des tensions sont appliquées, générées par un composant d'alimentation (1) dans l'appareil de commande, le composant d'alimentation (1) coupe le fonctionnement respectif des composants de l'appareil de commande par une ligne RESET (7), selon lequel on surveille les tensions quant aux défauts par des bandes (19, 20) et des valeurs de consigne (18),
**caractérisé en ce qu'**
on lance un test dans la ligne RESET (7) de l'appareil de commande selon lequel ensuite le composant d'alimentation (1) coupe le fonctionnement des composants par des impulsions périodiques par la ligne RESET (7) pour une durée prédéfinie et un processeur (2) compte le temps compris entre les interruptions pour surveiller le mode de fonctionnement de la ligne RESET (7).

2. Procédé selon la revendication 1,
**caractérisé en ce qu'**
en cas de test, les limites (19, 20) des bandes sont alternativement placées au-dessus et en dessous des valeurs de consigne (18, 23) pour forcer l'interruption.

3. Procédé selon la revendication 1 ou 2,
**caractérisé en ce que**
le test est exécuté à chaque nouveau démarrage de l'appareil de commande.

4. Procédé selon l'une des revendications 1 à 3,
**caractérisé en ce que**
pour chaque défaut des tensions surveillées, on retient les composants jusqu'à ce que toutes les fonctions de surveillance du composant d'alimentation (1) signalent une absence de défaut pour les tensions.

5. Procédé selon l'une des revendications 1 à 4,
**caractérisé en ce que**
le composant d'alimentation (1) fournit deux tensions de références indépendantes l'une de l'autre, la première tension de référence étant utilisée pour réguler les tensions et la seconde tension de référence pour surveiller la tension de régulation.

6. Procédé selon l'une des revendications 1 à 5,
**caractérisé en ce que**'
en cas d'échec du test, on émet un signal d'avertissement et/ou on bloque les fonctions de l'appareil de commande.

7. Appareil de commande permettant d'exécuter toutes les étapes du procédé selon l'une des revendications 1 à 6,
**caractérisé en ce que**
l'appareil de commande comporte un composant d'alimentation (1) qui alimente les composants (2-6, 50-52) de l'appareil de commande en leur fournissant les tensions nécessaires et il est relié aux composants (2-6, 50-52) par la ligne RESET (7) et **en ce qu'**un processeur (2) de l'appareil de commande comporte des moyens pour exécuter le test de la ligne de RESET (7).

8. Appareil de commande selon la revendication 7,
**caractérisé en ce que**
le composant d'alimentation (1) comporte des moyens pour fournir au moins deux tensions de références indépendantes (VREF, VREGEL).

9. Appareil de commande selon la revendication 8,
**caractérisé en ce que**
le composant d'alimentation (1) comporte au moins deux sources de tension (35, 36) indépendantes l'une de l'autre pour fournir les tensions de références (VREGEL, VREF).

10. Appareil de commande selon la revendication 8,
**caractérisé en ce que**
le composant d'alimentation (1) comporte une source de tension (39) et aux moins deux convertisseurs d'impédance (37, 38) pour fournir les tensions de références.
